Europäisches Patentamt

European Patent Office

Office européen des brevets

(19)

(11) Veröffentlichungsnummer: **0 193 157**
**A1**

# EUROPÄISCHE PATENTANMELDUNG

(12)

(21) Anmeldenummer: 86102388.5

(22) Anmeldetag: 24.02.86

(51) Int. Cl.⁴: **G11C 8/00**

(30) Priorität: 25.02.85 DE 3506603

(43) Veröffentlichungstag der Anmeldung:
03.09.86 Patentblatt 86/36

(84) Benannte Vertragsstaaten:
AT BE DE FR GB IT NL SE

(71) Anmelder: **Siemens Aktiengesellschaft Berlin und München**
**Wittelsbacherplatz 2**
**D-8000 München 2(DE)**

(72) Erfinder: **Tielert, Reinhard, Dr.**
**Lehrer-Götz-Weg 24**
**D-8000 München 82(DE)**

(54) Schaltungsanordnung mit einer matrixförmigen Speicheranordnung zur variabel einstellbaren Verzögerung digitaler Signale.

(57) Eine Schaltungsanordnung mit einer matrixförmigen Speicheranordnung zur variabel einstellbaren Verzögerung digitaler Signale enthält als speichernde Elemente an sich bekannte 3-Transistorzellen mit überlappenden Schreib-/Lesezyklen, einen vom Eingangsdatentakt taktgesteuerten, kontinuierlich fortschaltbaren, jederzeit rücksetzbaren Zeilenwähler ($P_1...P_n$), der je die zwei in der Phase gegeneinander versetzte Signalausgänge je Wählschritt aufweist, die jeweils eine Schreibwortleitung (ws) bzw. eine Lesewortleitung (wl) ansteuern, welche je Zeile der Matrix vorgesehen sind, je Spalte zwei getrennte Bitleitungen (Schreibbitleitung (bs), Lesebitleitung (bl)), die jeweils mit allen Speicherzellen einer Spalte zusammengeschaltet sind, je Spalte einen abtrennbaren, speichernden Verstärker ($A_1...A_m$), dessen Eingang (i) mit der Lesebitleitung (bl) der ihm zugeordneten Spalte und dessen Ausgang (o) mit der Schreibbitleitung (bs) der ihm nachgeordneten Spalte verbunden ist und als ein ihm zugeordneter Datenausgang ($Z_1...Z_m$) dient, einen Dateneingang für die zu verzögernden Datensignale, der mit der Schreibbitleitung (bs) der ersten Spalte und einem unverzögerten Datenausgang ($Z_0$) verbunden ist sowie einen Rücksetzeingang ($\overline{Reset}$), der mit Setzeingängen (a,s̄) eines ersten Gliedes ($P_1$) des Zeilenwählers sowie mit den Rücksetzeingängen (r̄) der restlichen Glieder ($P_2...P_n$) des Zeilenwählers verbunden ist. Der zeitliche Abstand zwischen Rücksetzimpulsen ($\overline{Reset}$) wird derart gewählt, daß er gleich der geforderten Verzögerungszeit ist, welche zwischen dem unverzögerten Datenausgang ($Z_0$) und dem ersten verzögerten Datenausgang ($Z_1$) eingestellt werden soll.

FIG 1

Schaltungsanordnung mit einer matrixförmigen Speicheranordnung zur variabel einstellbaren Verzögerung digitaler Signale.

Die vorliegende Erfindung betrifft eine Schaltungsanordnung zur variabel einstellbaren Verzögerung digitaler Signale mit einer matrixförmigen Speicheranordnung.

Auf dem Gebiet der digitalen Signalverarbeitung sowie auf dem Gebiet der Nachrichtentechnik werden vielfach Einrichtungen benötigt, mit deren Hilfe definierte Verzögerungen von digitalen Datenströmen bewirkt werden können. Definierte Verzögerungen werden beispielsweise zum Ausgleich von Laufzeiten verwendet. Bei einer konstanten Anzahl von gewünschten Verzögerungstakten bietet sich im allgemeinen als Verzögerungseinrichtung eine Anordnung mit einem Schieberegister an. Soll jedoch die Verzögerung variabel einstellbar sein, so ergeben sich bei Verwendung von Schieberegistern bestimmte Probleme.

Es ist auch bekannt, Datenströme definiert mittels einer Anordnung aus Standardschaltungen und Speicherbausteinen zu verzögern. In einer derartigen Anordnung werden die Bestandteile des Datenstromes in einem frei adressierbaren Speicher abgelegt. Dieser Speicher wird durch einen Decoder angesteuert, der seinerseits durch einen (oder mehrere) Zähler angesteuert wird. Dabei wird die Dauer der Verzögerung durch den Abstand der Zähler-Rücksetzimpulse gegeben. Da die Speicherzellen derartiger frei adressierbarer Speicher je Takt nur jeweils lesen oder - schreiben können, ergibt sich dabei die Notwendigkeit, entweder die Speicher mit der doppelten Taktrate zu betreiben oder zwischen zwei Speichereinheiten in einem Multiplex-Betrieb hin-und herzuschalten. Die erste Lösung dieses Problems hat den Nachteil, daß die maximale Datentaktfrequenz nur halb so groß wie die maximale Speicherzyklusfrequenz sein darf. Die Lösung des letzteren Problems erfordert aufwendige Logikschaltungen zur Adreßsteuerung und einer erforderlichen Umordnung der Daten. Für eine integrierbare Realisierung einer derartigen Schaltungsanordnung entstehen außerdem Nachteile wegen des hohen Platzbedarfs der notwendigen Multiplexer und wegen der erforderlichen umfangreichen Verdrahtung.

Der vorliegenden Erfindung liegt die Aufgabe zugrunde, eine Schaltungsanordnung der eingangs genannten Art zu - schaffen, mittels derer definierte, variabel einstellbare Verzögerungen erzielt werden können, die durch eine integrierte Schaltungsanordnung realisierbar ist, die einen geringen Flächenbedarf benötigt und gegenüber dem Stand der Technik höhere Datenraten zuläßt. Insbesondere besteht die Aufgabe darin, eine Schaltungsanordnung zu schaffen, die für die Integration in MOS-Technik besonders geeignet ist.

Die Aufgabe, die der vorliegenden Erfindung zugrundeliegt, wird durch eine Schaltungsanordnung zur variabel einstellbaren Verzögerung digitaler Signale mit einer matrixförmigen Speicheranordnung gelöst, die durch die in dem kennzeichnenden Teil des Patentanspruchs 1 angegebenen Merkmale beschrieben ist.

Vorteilhafte Weiterbildungen der vorliegenden Erfindung sind durch die in den Unteransprüchen angegebenen Merkmale gekennzeichnet.

Im folgenden wird die Erfindung anhand mehrerer, Ausführungsbeispiele für die vorliegende Erfindung betreffender Figuren im einzelnen erläutert.

Fig.1 zeigt ein Blockschaltbild der Schaltungsanordnung gemäß einem bevorzugten Ausführungsbeispiel, bei der ein Zeilenwähler, eine matrixförmige Speicheranordnung, Regeneratorschaltungen sowie eine Taktsteuerung vorgesehen sind.

Fig.2 zeigt ein Impuls/Zeit-Diagramm zur Erläuterung der Arbeitsweise der Schaltungsanordnung gemäß Fig.1.

Fig.3 zeigt die in Fig.1 enthaltene symbolische Darstellung und ein Prinzipschaltbild einer 3-Transistorspeicherzelle, wie sie n x m-fach in der Speicheranordnung gemäß Fig.1 verwendet wird.

Fig.4 zeigt die in Fig.1 enthaltene symbolische Darstellung sowie ein Prinzipschaltbild eines Regenerators (Verstärkerschaltung), wie sie m-fach in der Schaltungsanordnung gemäß Fig.1 verwendet wird.

Fig.5 zeigt die in Fig.1 enthaltene symbolische Darstellung einer Zeilenwählerstufe sowie deren Prinzipschaltbild, welche Stufen in der Schaltungsanordnung gemäß Fig.1 n-fach verwendet werden.

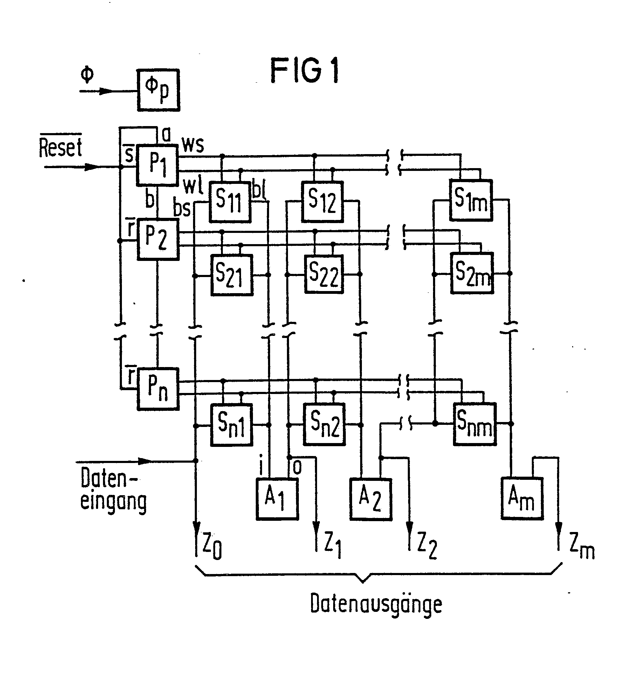

Wie bereits erläutert, zeigt Fig.1 ein bevorzugtes Ausführungsbeispiel für eine Schaltungsanordnung zur variabel einstellbaren Verzögerung digitaler Signale mit einer matrixförmigen Speicheranordnung gemäß der vorliegenden Erfindung.

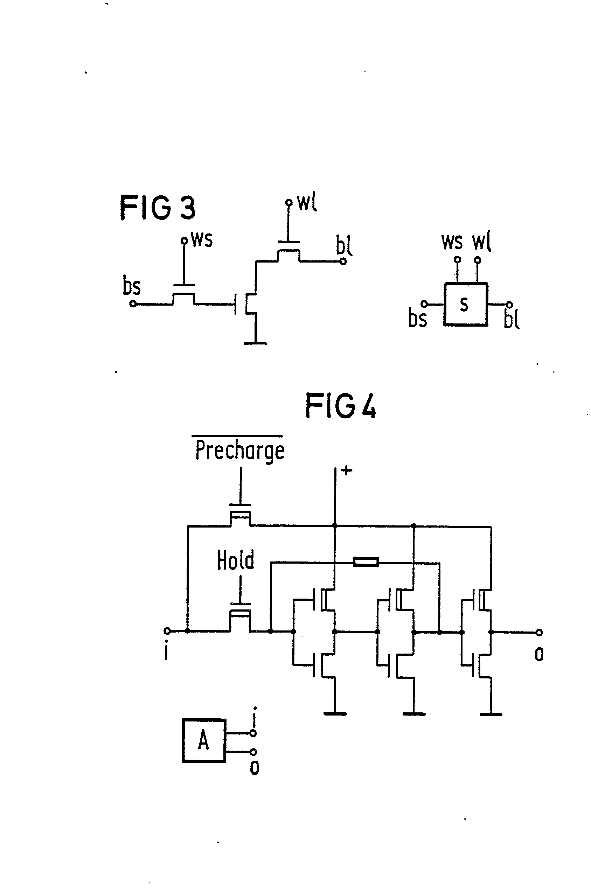

Die gezeigte Schaltungsanordnung enthält einen Dateneingang D, einen Rücksetzeingang $\overline{Reset}$, einen Takteingang $\emptyset$, der eine Taktsteuerung $\emptyset_p$ synchronisiert, sowie mehrere Datenausgänge $Z_0...Z_m$. Außerdem ist ein Zeilenwähler mit Stufen $P_1...P_n$ vorgesehen, bei dem die Stufen in einer Reihe zusammengeschaltet sind, bei dem die erste Stufe $P_1$ mit einem Setzeingang $\overline{s}$ und einem Signaleingang a und die restlichen Stufen $P_2...P_n$ mit ihren jeweiligen Rücksetzeingängen $\overline{r}$ an den Rücksetzeingang $\overline{Reset}$ angeschlossen sind, bei dem jeweils ein Signalausgang b mit dem Signaleingang a der jeweils folgenden Stufe verbunden ist und bei dem jeweils je Stufe eine Schreibwortleitung ws und eine Lesewortleitung wl vorgesehen sind. Als speichernde Elemente sind in der matrixförmigen Speicheranordnung an sich bekannte 3-Transistorspeicherzellen mit überlappenden Schreib-/Lesezyklen vorgesehen - (vergl. Fig.3). Der kontinuierlich fortschaltbare, jederzeit rücksetzbare Zeilenwähler $P_1...P_n$ wird von einem Eingangsdatentakt taktgesteuert. Er weist je Wählschritt, nämlich je Stufe, zwei in der Phase gegeneinander versetzte Signalausgänge -nämlich die Schreibwortleitung ws bzw. die Lesewortleitung wl - auf, die je Zeile der Matrix vorgesehen sind. In der Speicheranordnung sind je Spalte zwei getrennte Bitleitungen -nämlich eine Schreibbitleitung bs und eine Lesebitleitung bl -vorgesehen, die jeweils mit allen Speicherzellen einer Spalte zusammengeschaltet sind. Außerdem ist je Spalte ein abtrennbarer, speichernder Verstärker $A_1...A_m$ vorgesehen, dessen Eingang i jeweils mit der betreffenden Lesebitleitung bl der ihm zugeordneten Spalte und dessen Ausgang o jeweils mit der Schreibbitleitung bs der ihm nachgeordneten Spalte verbunden ist und als den jeweiligen Verstärkern zugeordnete Datenausgänge $Z_1...Z_m$ dient. Der Dateneingang D für die zu verzögernden Datensignale ist mit der Schreibbitleitung bs der ersten Spalte und einem unverzögerten Datenausgang $Z_0$ verbunden. Die weiteren Datenausgänge $Z_1...Z_m$ sind gegenüber dem unverzögerten Signalausgang $Z_0$ derart verzögert, daß der zeitliche Abstand zwischen Rücksetzimpulsen Reset derart gewählt wird, daß er gleich der geforderten Verzögerungszeit ist, welche zwischen dem unverzögerten Datenausgang $Z_0$ und dem ersten verzögerten Datenausgang $Z_1$ eingestellt werden soll.

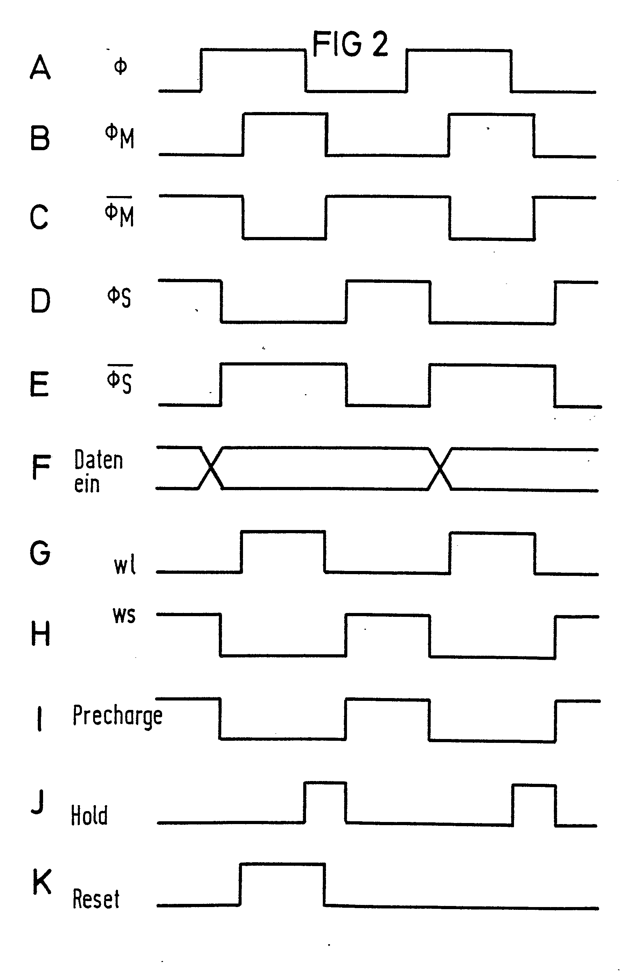

Wie bereits erläutert, zeigt Fig.2 ein Impuls/Zeit-Diagramm zur Erläuterung der Arbeitsweise der erfindungsgemäßen Schaltungsanordnung.

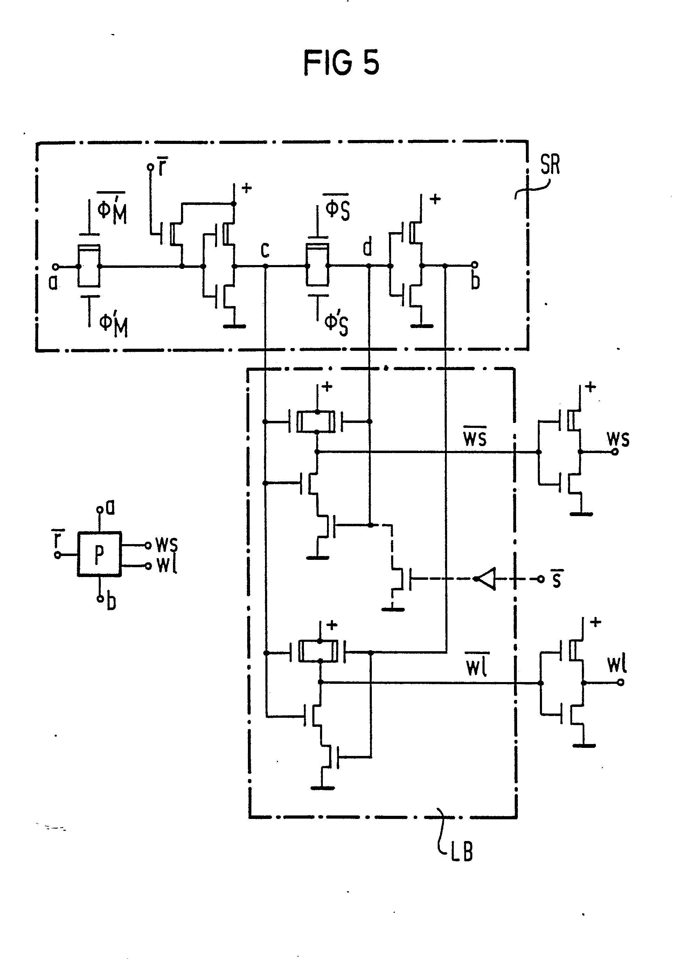

In Fig.2A ist der an die Taktsteuerung gelegte Grundtakt $\emptyset$ dargestellt. Daraus abgeleitete Hilfstakte zur Steuerung des Zeilenwählers (vergl. auch Fig.5), nämlich $\emptyset_M$, $\overline{\emptyset_M}$, $\emptyset_S$ und $\overline{\emptyset_M}$, sind in Fig.2B, 2C, 2D bzw. 2E gezeigt. Fig.2F zeigt die Phasenlage des Eingangsdatenstromes in bezug auf den Grundtakt $\emptyset$. In Fig.2G und 2H sind die Ausgangssignale des Zahlenwählers, nämlich das Lesewort-bzw. das Schreibwortleitungssignal wl bzw. ws, dargestellt. In Fig.2I und 2J sind ein Precharge-Signal bzw. ein Hold-Signal gezeigt, die zur Steuerung der Regeneratorschaltungen (vergl. auch Fig.4) verwendet werden. Fig.2K zeigt schließlich die Phasenlage des erforderlichen Reset-Signals in bezug auf den Grundtakt $\emptyset$.

Fig.3 zeigt, wie bereits erläutert, eine Darstellung der verwendeten 3-Transistorspeicherzelle, deren Prinzip darauf beruht, daß die zu speichernde Information dynamisch auf dem Gate eines MOS-Transistors (des mittleren der drei Transistoren) gespeichert wird. Diese an sich bekannte 3-Transistorspeicherzelle wird -wie durch die Klemmenbezeichnung angegeben -in einer speziellen Betriebsart verwendet, bei der zum Lesen und Schreiben getrennte Bitleitungen benutzt werden (vergl. Fig.1), wodurch sich die Möglichkeit des Lesens und Schreibens in einem einzigen Taktzyklus ergibt, was vorteilhafterweise zu der angestrebten Zeitersparnis führt.

Fig.4 zeigt, wie bereits erläutert, eine Darstellung eines Regenerators. Die Aufgabe dieses Regenerators besteht darin, das auf der seinem Eingang i zugeordneten Lesebitleitung bl auftretende geschwächte Lesesignal auf den Normalpegel zu verstärken und dieses auf die seinem Ausgang o zugeordnete, kapazitiv stark belastete Schreibbitleitung bs auszugeben. Die Schaltung dieses Regenerators enthält eine dreistufige Inverteranordnung mit einem darin enthaltenen Mitkopplungspfad. Der Inverteranordnung ist ein Schalter vorgeordnet, der jedesmal dann, wenn die Lesebitleitung für die nächsten Taktzyklus vorgeladen wird -gesteuert von dem Hold-Signal -die Inverteranordnung von dem Eingang i abtrennt und dadurch die eingespeicherte Information festhält. Dabei wird das Vorladen von einem durch das Precharge-Signal gesteuerten weiteren Schalter bewirkt.

Die in Fig.1 gezeigte Schaltungsanordnung kann gemäß einer vorteilhaften Weiterbildung der Erfindung entsprechend der Wortbreite der Eingangsdaten mehrfach vorgesehen sein, wobei die Wortschreib-bzw. Wortleseleitungen ws bzw. wl dieser Speichermatrizen parallelgeschaltet und mit einem gemeinsamen für diese Speichermatrizen vorgesehenen Zeilenwähler $P_0...P_n$ verbunden sind. Das Reset-Signal, das dem Rücksetzeingang $\overline{Reset}$ zugeführt wird, kann gemäß einer anderen Weiterbildung mit der vorliegenden Erfindung mit den Eingangssignalen bereitgestellt werden, d.h. von diesen abgeleitet werden.

Eine andere vorteilhafte Weiterbildung der Erfindung sieht vor, daß ein Reset-Signal intern in dem die Schaltungsanordnung aufweisenden Chip durch einen von außen rücksetzbaren zyklischen Zähler erzeugt wird. Vorteilhafterweise werden aus der Schaltungsanordnung nur diejenigen Datenausgänge herausgeführt, die für den jeweiligen Verwendungszweck der Schaltungsanordnung erforderlich sind. Im Interesse einer Typen-Beschränkung ist es jedoch auch vorteilhaft, soviel Datenausgänge aus dem Chip herauszuführen, wie es denkbaren Verwendungsfällen für die vorliegende Erfindung entsprechen würde. Die in Fig.1 gezeigten Verstärker $A_1...A_m$ sind invertierend. Eine andersgeartete Ausführungsform der vorliegenden Erfindung sieht vor, daß die Verstärker $A_1...A_m$ nichtinvertierend sind, daß jedoch dementsprechend jeweils ein Inverter an jedem zweiten Datenausgang der Schaltungsanordnung vorgesehen ist.

Eine andere Weiterbildung der Erfindung sieht vor, daß der Zeilenwähler $P_1...P_n$ jeweils aus einem Schieberegister, einem Verknüpfungsblock und zwei Ausgangstreibern mit Ausgängen ws bzw. wl je Glied des Zeilenwählers besteht und daß die Phasenlagen und Impulsbreiten der Ausgangssignale in den Ausgängen ws und wl durch entsprechende Verknüpfungen dreier in dem Schieberegister vorhandener Abgriffe bewirkt werden.

Fig.5 zeigt, wie bereits erläutert, die Darstellung einer Zeilenwählerstufe P. In einem Schieberegisterblock SR sind zwei dynamische Registerstufen, die durch mittels Hilfstakten $\overline{\emptyset'_M}$, $\emptyset'_M$; $\overline{\emptyset_S}$, $\emptyset_S$ gesteuerte Schalter voneinander bzw. von dem Signaleingang a trennbar sind, vorgesehen. Die Hilfstakte $\overline{\emptyset'_M}$ und $\emptyset'_M$ entsprechen den Hilfstakten $\overline{\emptyset_M}$ und $\emptyset_M$ gemäß Fig.2. Sie stellen allerdings Ergebnissignale einer Verknüpfung der betreffenden in Fig.2 gezeigten Signale mit dem Reset-Signal dar. Diese Verknüpfung bewirkt ein Schließen des Schalters am Eingang des Schieberegisterblocks SR für die Dauer des Reset-Signals. In einem Logikblock LB sind zwei Verknüpfungsglieder vorgesehen, die die an den Punkten c, d, b, auftretenden Signale nach folgenden Funktionen miteinander verknüpfen:

$$\overline{ws} = \overline{c \wedge \overline{d}}$$

$$\overline{wl} = \overline{c \wedge \overline{b}}$$

Die Ausgangssignale $\overline{ws}$ und $\overline{wl}$ des Logikblocks LB werden mittels invertierender Treiber auf die Schreibwortleitung ws bzw. die Lesewortleitung der zugehörigen Zeile der matrixförmigen Speicheranordnung geschaltet. Es ist für die Stufen $P_2...P_n$ des Zeilenwählers gemäß Fig.1 jeweils ein Reset-Eingang $\overline{r}$ vorgesehen. An dessen Stelle tritt bei der Stufe $P_1$ ein Setzeingang $\overline{s}$, wie dies in Fig.5 gestrichelt angedeutet ist.

Die erfindungsgemäße Schaltungsanordnung ist von ihrem Aufbau her insbesondere dazu geeignet, als monolithisch integrierte MOS-Schaltung realisiert zu werden.

## Ansprüche

1. Schaltungsanordnung mit einer matrixförmigen Speicheranordnung zur variabel einstellbaren Verzögerung digitaler Signale,

dadurch **gekennzeichnet,**

-daß als speichernde Elemente an sich bekannte 3-Transistorzellen mit überlappenden Schreib-/Lesezyklen vorgesehen sind,

-daß ein vom Eingangsdatentakt taktgesteuerter, kontinuierlich fortschaltbarer, jederzeit rücksetzbarer Zeilenwähler - $(P_1...P_n)$ vorgesehen ist, der je zwei, in der Phase gegeneinander versetzte Signalausgänge je Wählschritt aufweist, die jeweils eine Schreibwortleitung (ws) bzw. eine Lesewortleitung (wl) ansteuern, welche je Zeile der Matrix vorgesehen sind,

-daß je Spalte zwei getrennte Bitleitungen, nämlich eine Schreibbitleitung (bs) und eine Lesebitleitung (bl) vorgesehen sind, die jeweils mit allen Speicherzellen einer Spalte zusammengeschaltet sind,

-daß je Spalte ein abtrennbarer, speichernder Verstärker - $(A_1...A_m)$ vorgesehen ist, dessen Eingang (i) mit der Lesebitleitung (bl) der ihm zugeordneten Spalte und dessen Ausgang (o) mit der Schreibbitleitung (bs) der ihm nachgeordneten Spalte verbunden ist und als ein ihm zugeordneter Datenausgang $(Z_1...Z_m)$ dient,

-daß ein Dateneingang für die zu verzögernden Datensignale mit der Schreibbitleitung (bs) der ersten Spalte und einem unverzögerten Datenausgang $(Z)_0$ verbunden ist,

-daß ein Rücksetzeingang (Reset) mit Setzeingängen - (a, $\overline{s}$ ) eines ersten Gliedes $(P_1)$ des Zeilenwählers sowie mit den Rücksetzeingängen ( $\overline{r}$ ) der restlichen Glieder - $(P_2...P_n)$ des Zeilenwählers verbunden ist, und

-daß der zeitliche Abstand zwischen Rücksetzimpulsen - (Reset) derart gewählt wird, daß er gleich der geforderten Verzögerungszeit ist, welche zwischen dem unverzögerten Datenausgang $(Z_0)$ und dem ersten verzögerten Datenausgang $(Z_1)$ eingestellt werden soll.

2. Schaltungsanordnung nach Anspruch 1, dadurch **gekennnzeichnet**, daß entsprechend der Wortbreite der Eingangsdaten eine Vielzahl von Speichermatrizen vorgesehen sind, deren Wortschreib-bzw. Wortleseleitungen (ws bzw. wl) parallelgeschaltet und mit dem gemeinsam für diese Speichermatrizen vorgesehenen Zeilenwähler ($P_0$ ...$P_n$) verbunden sind.

3. Schaltungsanordnung nach Anspruch 1 oder 2, dadurch **gekennzeichnet** , daß ein Reset-Signal, das dem Rücksetzeingang (Reset) zugeführt wird, mit den Eingangssignalen bereitgestellt wird.

4. Schaltungsanordnung nach Anspruch 1 oder 2, dadurch **gekennzeichnet**, daß ein Reset-Signal intern in dem die Schaltungsanordnung aufweisenden Chip durch einen von außen einstellbaren zyklischen Zähler erzeugt wird.

5. Schaltungsanordnung nach einem der vorhergehenden -Ansprüche, dadurch **gekennzeichnet**, daß aus der Schaltungsanordnung nur diejenigen Datenausgänge herausgeführt sind, die für den jeweiligen Verwendungszweck der Schaltungsanordnung erforderlich sind.

6. Schaltungsanordnung nach einem der vorhergehenden Ansprüche, dadurch **gekennzeichnet**, daß die Verstärker - $(A_1...A_m)$ invertierend sind.

7. Schaltungsanordnung nach einem der Ansprüche 1 bis 5, dadurch **gekennzeichnet**, daß die Verstärker ($A_1...A_m$ ) nichtinvertierend sind und daß dementsprechend jeweils ein Inverter an jedem zweiten Datenausgang ($Z_1...Z_m$) angeordnet ist.

8. Schaltungsanordnung nach einem der vorhergehenden Ansprüche, dadurch **gekennzeichnet**, daß sie als monolithisch integrierte MOS-Schaltung realisiert ist.

9. Schaltungsanordnung nach Anspruch 1, dadurch **gekennzeichnet**, daß der Zeilenwähler ($P_1...P_n$) jeweils aus einem Schieberegister (SR), einem Verknüpfungsblock - (LB) und zwei Ausgangstreibern mit Ausgängen (ws bzw. wl) je Glied des Zeilenwählers besteht und daß die Phasenlagen und Impulsbreiten der Ausgangssignale an den Ausgängen (ws und wl) durch entsprechende Verknüpfungen dreier in dem Schieberegister (SR) vorhandener Abgriffe bewirkt werden.

# FIG 1

FIG 2

| | | |
|---|---|---|
| A | $\Phi$ | |
| B | $\Phi_M$ | |
| C | $\overline{\Phi_M}$ | |
| D | $\Phi_S$ | |
| E | $\overline{\Phi_S}$ | |
| F | Daten ein | |
| G | wl | |
| H | ws | |
| I | Precharge | |
| J | Hold | |
| K | Reset | |

**FIG 3**

**FIG 4**

0 193 157

# FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-3 893 088 (BELL)<br><br>* Figuren 10A,5A; Spalte 17, Zeile 44 - Spalte 18, Zeile 43 *<br><br>--- | 1,2,4,8 | G 11 C 8/00 |
| Y | EP-A-0 031 950 (NEC CORP.)<br><br>* Figuren 13,16; Seite 21, Zeilen 17-23; Seite 22, Zeile 20 - Seite 23, Zeile 1 *<br><br>--- | 1,2,4,8 | |
| A | US-A-3 731 287 (J. LELAND SEELY)<br>* Figuren 2,4A,4B; Zusammenfassung *<br><br>----- | 1,4,8 | |

| | RECHERCHIERTE SACHGEBIETE (Int. Cl.4) |
|---|---|
| | G 11 C 8/00 |

Der vorliegende Recherchenbericht wurde für alle Patentansprüche erstellt.

| Recherchenort<br>DEN HAAG | Abschlußdatum der Recherche<br>09-06-1986 | Prüfer<br>SONIUS M.E. |
|---|---|---|